# EUROPÄISCHE PATENTSCHRIFT

(11) **EP 2 183 772 B1**
(45) Veröffentlichungstag und Bekanntmachung des Hinweises auf die Patenterteilung: **09.02.2011**
(21) Anmeldenummer: 09777553.0
(22) Anmeldetag: 30.07.2009
(51) Int. Cl.: H01L 21/68

(54) **VORRICHTUNG UND VERFAHREN ZUM TRANSPORTIEREN VON SUBSTRATEN**
DEVICE AND METHOD FOR TRANSPORTING SUBSTRATES
PROCEDE ET DISPOSITIF DE TRANSPORT DE SUBSTRATS

(30) Priorität: 01.09.2008 DE 102008045255
(43) Veröffentlichungstag der Anmeldung: 12.05.2010
(73) Patentinhaber: RENA GmbH, 78148 Gütenbach (DE)
(72) Erfinder: REUSTLE, Peter, 74399 Walheim (DE); GUTEKUNST, Mathias, 72221 Haiterbach (DE); LÜTKE NOTARP, Dietmar, 50931 Köln (DE)
(74) Vertreter: Stürken, Joachim
(86) Internationale Anmeldenummer: PCT/EP2009/005531
(87) Internationale Veröffentlichungsnummer: WO 2010/022843

(56) Entgegenhaltungen:
- EP-A- 1 458 013
- JP-A- 2008 277 478
- US-A1- 2005 265 814
- "PROGRAMMABLE THREE-FINGER GRIPPER" IBM TECHNICAL DISCLOSURE BULLETIN, IBM CORP. NEW YORK, US, Bd. 33, Nr. 12, 1. Mai 1991 (1991-05-01), Seite 59/60, XP000121459 ISSN: 0018-8689

## Beschreibung

Die Erfindung betrifft das Transportieren bzw. Handhaben von Substraten, z. B. als Wafer oder Solarzellen während der Herstellung derselben und/oder bei der späteren Verarbeitung dieser Güter. Diese bestehen z. B. aus dünnen Siliziumscheiben. Von daher sind sie sehr bruchempfindlich. Deshalb müssen sie beim Aufnehmen bzw. Ergreifen und Ablegen, oder allgemein beim Handhaben sehr stressfrei, d. h. ohne wesentliche Krafteinwirkung behandelt werden. Hinzu kommt, dass die bekannten Anlagen oder Prozesskammern zur Behandlung dieser Güter in der Regel ein sehr präzises Positionieren der Substrate an den Ablagestellen erfordern.

Die Druckschrift DE 202 12 107 U1 beschreibt einen Greifer für Bauteile, deren Lage beim Aufnehmen zunächst undefiniert ist. Nach dem Ergreifen des Gutes wird mittels mindestens einer Kamera, die an der Greifvorrichtung installiert ist, die Lage des Gutes am Greifer bestimmt und zwar während der Transportbewegung zur nächsten Position, d. h. zur Zielposition. Eine Steuereinrichtung wertet die Daten der Kamera aus, wodurch das präzise Ablegen des Gutes am Zielort mittels der Anlagensteuerung und der dort gespeicherten Positionsdaten des Zieles möglich ist. Zum Ergreifen des Gutes werden die bekannten Vakuumgreifer, Saugvorrichtungen und vorzugsweise Bernoulli-Greifer beschrieben. Diese haben jedoch den Nachteil, dass besonders beim Aufnehmen und dem vertikalen Ablegen des Gutes ein horizontales Verschieben bzw. Auswandern oder Wegschwimmen desselben erfolgen kann. Dieses Wegschwimmen ist mindestens beim Ablegen nicht mehr korrigierbar. Die Folge ist ein ungenaues Ablegen auf der Zielposition.

Die Druckschrift DE 197 55 694 C2 beschreibt einen Bernoulli-Greifer zum Transport von Wafern. Zur Vermeidung des Auswanderns, d. h. zur Sicherheit dienen am Umfang des Gutes verteilt angeordnete verstellbare Führungsarme mit zylinderförmigen Enden, die über die Oberfläche des Greifers und damit über das Gut hinausragen. Die Führungsarme werden an die Geometrie und Maßtoleranzen des zu greifenden Gutes angepasst. Die zylinderförmigen Enden begrenzen das Gut, wodurch ein unzulässiges radiales Auswandern vermieden wird.

Der Träger bzw. Greifer ist an einem Manipulator befestigt, der ihn an eine Abholposition bringt, an der das Gut aufgenommen werden soll und an eine andere Stelle führt, an der das Gut wieder abgelegt werden soll. Dies setzt jedoch voraus, dass sich das abzuholende Gut in einer, dem Steuerungssystem bekannten Lage der jeweiligen Position befindet. Andernfalls käme es durch einen möglichen Zusammenstoß zu einer Beschädigung des Gutes und/oder zu einer anschließend ungenauen Ablage in der Zielposition.

Während der Behandlung eines Gutes in einer Anlagenposition, d. h. in einer Behandlungsstation besteht in der Regel stets die Gefahr des Veränderns der Lage des Gutes. Weil das Steuerungssystem des Manipulators dann von der tatsächlichen Lage des abzuholenden Gutes keine Kenntnis hat, kann es drauf auch nicht reagieren.

Aufgabe der Erfindung ist es, eine Greifvorrichtung bereitzustellen, insbesondere für bruchempfindliche Güter wie siliziumbasierte Wafer oder Solarzellen, die innerhalb von bestimmten Abmessungen beliebige Größen, d. h. unterschiedliche Nennmaße aufweisen können, die von einer Abholposition ungenau liegendes Gut stressfrei aufnehmen, in horizontaler oder geneigter Lage transportieren und in einer Zielposition exakt positioniert und unversehrt ablegen kann.

Gelöst wird die Aufgabe durch die Vorrichtung gemäß Patentanspruch 1 und durch das Verfahren gemäß Patentanspruch 19. Die Unteransprüche beschreiben vorteilhafte Ausführungen der Erfindung.

Die Erfindung besteht aus mindestens einer Greifvorrichtung, die z. B. an einem Handhabungsgerät oder einem Roboterarm einer Produktionsanlage befestigt ist oder sind. Die jeweilige dreidimensionale Position des Handhabungsgerätes oder des Roboterarmes einschließlich der Ausrichtung der Greifvorrichtung sind im Steuerungssystem der Produktionsanlage zur Nass- oder Trockenbehandlung des Gutes bekannt. Damit ist die exakte Position und Lage der Greifvorrichtung bekannt. In der Regel sind auch die exakten Positionen bzw. die Koordinaten der Ablagestellen der gesamten Anlage im Steuerungssystem bekannt, an denen von der Greifvorrichtung Güter aufzunehmen bzw. abzulegen sind. Nicht genau bekannt ist jedoch die Lage der Güter auf den Ablagestellen der jeweiligen Anlagenposition. Das Gut kann sich z. B. während einer Trockenbehandlung oder Nassbehandlung unbemerkt verschrieben. Insbesondere wenn das Gut ein geringes Gewicht aufweist, wie z. B. eine Solarzelle, dann muss mit einer horizontalen Verschiebung während der Behandlung gerechnet werden. Eine Verschiebung im Bereich von weniger als einem Millimeter kann schon für den nachfolgenden Prozess unzulässig groß sein.

Diese Verschiebung wird durch die erfindungsgemäße Greifvorrichtung jeweils für den nachfolgenden Prozess korrigiert. Hierzu dienen Positionieraktoren, die an der Greifvorrichtung angeordnet sind und vom Steuerungssystem der gesamten Anlage ebenfalls gesteuert und überwacht werden. Die Positionieraktoren haben reversierend bewegte Achsen mit jeweils daran befestigten Sensoren als Kantendetektoren und mindestens je einem Begrenzer. Damit sind die dreidimensionale Lage der Positionieraktoren, der Kantendetektoren und der Begrenzer auf der Greifvorrichtung, die Richtungen der Achsbewegungen der Positionieraktoren und ihre momentane Stellung, d. h. ihre Weginformationen im Steuerungssystem bekannt. Mit diesen Daten berechnet das Steuerungssystem die Koordinaten, die die Greifvorrichtung beim Ablegen des Gutes in der Zielposition einnehmen muss. Als Bezugspunkt oder Nullpunkt soll für die Beschreibung der Erfindung nachfolgend die Mitte der Greifvorrichtung definiert werden. Jedoch könnte dafür auch jede andere Lage auf der Greifvorrichtung festgelegt werden.

An der Unterseite der Greifvorrichtung ist in einer ersten Ausführung der Erfindung ein das Gut erfassender Greifer bevorzugt so angeordnet, dass sich das Zentrum des Greifers mit dem Bezugspunkt bzw. Nullpunkt auf einer gemeinsamen vertikalen Linie befinden. Als Greifer können z. B. die bekannten Vakuumgreifer, Saugvorrichtungen oder Bernoulli-Greifer verwendet werden. Des Weiteren ermöglicht die Erfindung in einer weiteren Ausführung auch die Verwendung von mechanischen Greifern als mindestens zwei Träger, die das Gut vom Rand her unterfahren und dieses durch vertikalen Hub tragend ergreifen und im Ziel absenkend ablegen. Bei ferromagnetischen Gütern sind auch magnetische Greifer verwendbar.

Der Greifer bzw. die Träger nehmen das zu greifende Gut an der Abholposition auf, transportieren es in horizontaler oder geneigter Lage und legen es an der Zielposition ab. Diese Positionen bzw. die Koordinaten aller Ablagestellen der Produktionsanlage sind im Steuerungssystem sehr genau bekannt. Desgleichen ist auch die momentane räumliche Bezugslinie bzw. der Nullpunkt der Greifvorrichtung, die von dem Handhabungsgerät oder einem Roboterarm steuernd bewegt wird, im Steuerungssystem fortlaufend bekannt. Unbekannt ist jedoch die genaue Lage des Gutes in der Abholposition. Hier muss stets mit einem Versatz, der eine maximale Größe erreichen kann, gerechnet werden.

Bei einem ersten möglichen Ablauf der Erfindung werden in der Abholposition vor dem Ergreifen des Gutes von der Greifvorrichtung am Umfang des abzuholenden Gutes verteilte mechanische Begrenzer derart positioniert, dass sich das Gut, ohne geklemmt zu werden, lateral nicht mehr verschieben kann. Hierzu werden die Begrenzer, die sich auf den Achsen der Positionieraktoren befinden, mittels dieser von einer maximal ausgefahrenen bzw. geöffneten Stellung, d. h. von einer Endposition in Richtung des Bezugspunktes, d. h. zum Rand des Gutes schließend bewegt. In räumlicher Nähe jedes Begrenzers und zusammen mit diesen an den Achsen der Positionieraktoren befestigt, befindet sich ein Kantendetektor, der das Gut bevorzugt berührungslos detektiert, z. B. eine Reflexlichtschranke mit Hintergrundausblendung oder eine Einweglichtschranke.

Beim Einfahren bzw. Schließen der Begrenzer mittels der Achsen der Positionieraktoren erkennt jeder Kantendetektor individuell die äußere Kante des auf der Abholposition liegenden Gutes. Bei Erreichen der Kante wird die individuelle Bewegung jedes Positionieraktors sofort angehalten. Der Begrenzer und der jeweils zugehörige Kantendetektor sind voneinander beabstandet so auf der Achse des Positionieraktors angeordnet, dass auch bei einem möglichen Nachlauf des Positionieraktors nach dem Erkennen der Kante des Gutes dieses von dem jeweiligen Begrenzer aus seiner ungenauen Lage nicht verschoben wird. Der Begrenzer stoppt unmittelbar vor der zu begrenzenden Kante des Gutes.

In Abwandlung der beschriebenen ersten Abläufe erlaubt die Erfindung auch das Ergreifen des in ungenauer Lage befindlichen Gutes mittels des Greifers oder der Träger, ohne die Begrenzer an der Kante zuvor positioniert zu haben. Der möglicherweise zusätzliche Lagefehler des Gutes durch ein Wegschwimmen oder Verschieben beim Aufnehmen wird in Kauf genommen. Erst nach dem Ergreifen des Gutes, d. h. während des gesamten Transportes bis spätestens zum Zeitpunkt des Beginns der Bewegung zum Ablegen werden die Begrenzer an der Kante des Gutes so positioniert, wie es oben beschrieben wurde. Das Ablegen in der Zielposition erfolgt dann mit den in Position befindlichen Begrenzern, wodurch ein Wegschwimmen oder Verschieben des Gutes verhindert wird. Somit kann auch bei diesem Ablauf das Gut in der Zielposition sehr genau abgelegt werden.

In Abhängigkeit von der Form des Gutes werden mindestens zwei Positionieraktoren auf der Greifvorrichtung angeordnet. So sind zum Beispiel bei einem kreisrunden Gut drei Positionieraktoren und Begrenzer erforderlich, um das in unbekannter Lage befindliche Gut eindeutig zu detektieren und zu begrenzen. Bei dem ersten beschriebenen Ablauf der Erfindung wird das Gut vom Greifer erst nach der bevorzugt gleichzeitigen Positionierung aller Begrenzer gegriffen. Wegen der erfindungsgemäß positionierten Begrenzer verändert sich die unbestimmte Lage des Gutes nach dem Ergreifen auch am Greifer nicht. Wie oben beschrieben, können diese drei Begrenzer auch erst nach dem Ergreifen mittels des Greifers bzw. Trägers an der Kante des Gutes positioniert werden. In diesem Falle kann sich die Lage des in der Abholposition befindlichen Gutes am Greifer durch ein Wegschwimmen oder Verschieben nochmals unbestimmt verändern, was jedoch die Positioniergenauigkeit in der Zielposition nicht beeinflusst.

Das Positionieren der Begrenzer an dem Rand des Gutes erfolgt mittels der Positionieraktoren und deren linear oder schwenkend verlagerbaren Achsen. Die Verlagerungen gehen von Endpositionen aus, die als Referenzpunkte im Steuerungssystem der Anlage bekannt sind. Die dabei individuell zurückgelegten Wege der Begrenzer zur mechanischen Begrenzung des Gutes werden zugleich von einem Wegmeßsystem als Wegdaten erfasst und an das Steuerungssystem weitergeleitet. Das Wegmeßsystem kann integraler Bestandteil des Positionieraktors sein. Es kann auch ein externer Sensor sein, der die Bewegung der Achse des Positionieraktors misst. Die Wegdaten, gemessen z. B. von bestimmten Referenzpunkten der Positionieraktoren, lassen eine eindeutige Bestimmung der Größe und der Richtung des Versatzes des Gutes zu, wenn entsprechend der Form des Gutes genügend viele Begrenzer am Umfang des Gutes verteilt positioniert worden sind.

Mit Hilfe des berechneten Versatzes und dessen Richtung kann dann das Gut auf der Zielposition exakt vom Handhabungsgerät oder einem Roboterarm abgelegt werden. Die Soll-Koordinaten der Zielposition oder der Bezugspunkt der Greifvorrichtung werden hierzu im Steuerungssystem um den Versatz vorzeichengerecht korrigiert.

Bei einem Gut mit der Form eines Vieleckes ist die Anzahl der Positionieraktoren so groß zu wählen, dass aus den Wegdaten der Positionieraktoren in Bezug zum Bezugspunkt bzw. Nullpunkt die Lage und Ausrichtung des Gutes eindeutig berechenbar ist. Eine über diese theoretische Anzahl hinausgehende Anzahl von Positionieraktoren erhöht die Genauigkeit der Positionierungen der Greifvorrichtung. So können bei einem quadratischen Gut, z. B. bei einer Solarzelle vier oder mehr Positionieraktoren verwendet werden.

Die Lage des Gutes auf der Abholposition bestimmt die Positionen der Begrenzer an der Greifvorrichtung, die bis zum Ablegen auf der Zielposition nicht verändert werden. Bei einem unbegrenzten Ergreifen des Gutes von der Abholposition bestimmt die dann eingenommene Lage des Gutes am Greifer bzw. Träger die Positionen der Begrenzer an der Greifvorrichtung, die bis zum Ablegen auf der Zielposition nicht verändert werden. Erst nach dem Ablegen werden die Begrenzer wieder ausgefahren bzw. geöffnet. Dies stellt erfindungsgemäß sicher, dass das Gut während des Ablegens nicht wegschwimmen oder sich verschieben kann. Die einmal eingegrenzte Lage des Gutes bleibt bis zum endgültigen Ablegen sehr genau erhalten. Damit vermeidet die Erfindung sehr vorteilhaft den ansonsten störenden Nachteil besonders der Vakuumgreifer, Saugvorrichtungen und Bernoulli-Greifer, nämlich das unbestimmte Wegschwimmen beim Ablegen des Gutes. Gleiches gilt für Träger, die das Gut in schräger Lage transportieren.

Die Erfindung wird nachfolgend an Hand der schematischen und nicht maßstäblichen Figuren 1 bis 4 detailliert beschrieben.

Die Figuren 1 zeigen den ersten möglichen Ablauf der Erfindung, wobei die Begrenzer in der Abholposition positioniert werden. Sinngemäß gilt dies auch für das Positionieren der Begrenzer erst nach dem Ergreifen des Gutes, wenn es sich an der Greifvorrichtung befindet.

Figur 1a zeigt in der Seitenansicht eine Greifvorrichtung mit einem Greifer und mit zwei Positionieraktoren, die sich zusammen mit Begrenzern im geöffneten Zustand über einem ungenau auf Ablagen abgelegten Gut befinden. Figur 1b zeigt die Greifvorrichtung mit Begrenzern, die an dem Rand des ungenau auf Ablagen liegenden Gutes positioniert sind. Figur 1c zeigt das Gut, das sich am Greifer angesaugt in der selben Lage befindet, wie auf der Abholposition.

Figur 2 zeigt ein kreisrundes Gut in der Draufsicht, das sich in Bezug zur Greifvorrichtung und deren geöffneten Begrenzern in einer unbestimmten Lage auf einer Abholposition oder gegriffen am Greifer bzw. den Trägern befindet.

Figur 3 zeigt das Gut in der selben Lage wie in Figur 2, jedoch mit Begrenzern, die erfindungsgemäß am Rand des Gutes positioniert worden sind.

Figur 4a zeigt in der Seitenansicht eine Greifvorrichtung mit zwei Trägern und mit zwei Positionieraktoren, die sich zusammen mit Begrenzern im geöffneten Zustand über einem ungenau auf Ablagen abgelegten Gut befinden. Figur 4b zeigt die Greifvorrichtung mit Begrenzern, die an dem Rand des ungenau auf Ablagen liegenden Gutes positioniert sind und mit Trägern, die das Gut zum Ergreifen unterfahren haben. Figur 4c zeigt das Gut in der selben Lage, das sich gegriffen auf den Trägern liegend befindet.

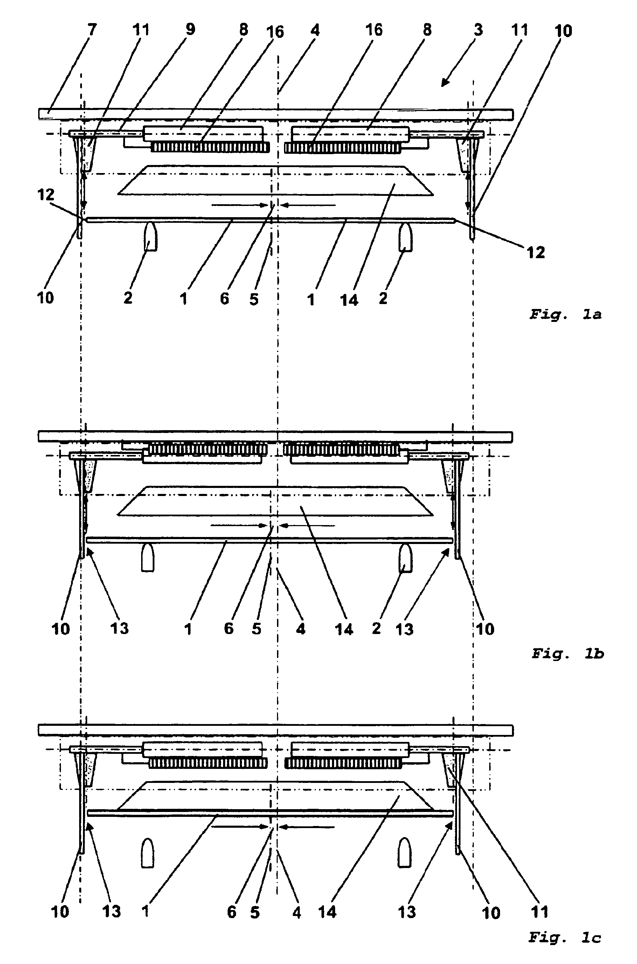

In **Figur 1a** liegt das Gut 1 in der Abholposition auf z. B. Ablagen 2 in einer Höhenlage, die dem Steuerungssystem der gesamten Anlage bekannt ist. Beispielhaft sind als Ablagen 2 mechanisch tragende Pins dargestellt. Als Ablage 2 können auch anders gestaltete Träger dienen. So kann als Ablage 2 auch eine Flüssigkeitsoberfläche dienen, auf der das Gut 1 schwimmt. Auch ein Gaspolster, insbesondere ein Luftpolster, ist als Ablage 2 realisierbar. Auch eine Kombination von mechanischen Ablagen 2 und Flüssigkeitsoberflächen oder Luftpolster zur Ablage von Gut ist realisierbar. Bei einer elektrolytischen Behandlung können dabei zum Beispiel die Ablagen 2 als elektrische Kontakte zur Stromübertragung auf das mindestens einseitig in der Behandlungsflüssigkeit befindliche Gut dienen.

Die Koordinaten der Abholpositionen der gesamten Produktionsanlage sind im Steuerungssystem bekannt. In der horizontalen Richtung ist das Gut 1 um einen unbestimmten Versatz 6 verschoben. Die hier in der Mitte der Greifvorrichtung 3 liegende Bezugslinie 4 bzw. der Nullpunkt trifft nicht die Gutmitte 5. Zwischen der Bezugslinie 4 und der Gutmitte 5 besteht ein Versatz 6, dessen Größe und Richtung im Steuerungssystem der Anlage nicht bekannt ist. Die Greifvorrichtung 3 befindet sich in der Abholposition über dem abzuholenden Gut 1. Ihre Lage in Bezug zur Abholposition d. h. die Lage der Bezugslinie 4 und ihre Höhenlage sind im Steuerungssystem bekannt, weil die Greifvorrichtung 3 mittels z. B. eines Adapters 7 mit einem nicht dargestellten Handhabungsgerät oder Roboterarm, die vom Steuerungssystem der gesamten Anlage gesteuert werden, verbunden ist.

An der Greifvorrichtung 3 sind mindestens zwei Positionieraktoren 8 angeordnet, jeweils bestehend aus einer reversierenden Achse 9 und einem damit mechanisch verbundenen oder integrieren Wegmeßsystem 16, die ebenfalls vom nicht dargestellten Steuerungssystem gesteuert und überwacht werden. An den Achsen 9 sind Begrenzer 10 befestigt, die sich in der Figur 1 a bis unterhalb der oberen Ebene der Ablagen 2 erstrecken. Die individuelle Bewegung jeder Achse 9 wird z. B. von einem inkrementalen Wegmeßsystem 16 in Bezug zu einem Referenzpunkt oder von einem absoluten Wegmeßsystem 16 als Weginformation individuell gemessen.

Die Begrenzer 10 sind bevorzugt so gestaltet, dass die Fläche im Bereich der Mantellinie klein ist, die zum Gut 1 weist, um die mögliche Berührungsfläche von Gut 1 und Begrenzer 10 klein zu halten. Geeignet sind z. B. runde, rechteckige oder dreieckige Querschnitte. Insbesondere für Nassprozesse eignen sich für die Begrenzer 10 Werkstoffe mit hydrophoben Eigenschaften, um eine Übertragung von Flüssigkeiten vom Gut zu den Begrenzern und umgekehrt zu vermeiden.

In der Nähe der Begrenzer 10 sind jeweils an den Achsen 9 des Weiteren Kantendetektoren 11 angeordnet, die die Kante 12 des Gutes 1 detektieren können. Hierzu dienen bevorzugt berührungslos messende optische Kantendetektoren, z. B. Reflexlichtschranken mit Hintergrundausblendung oder Einweglichtschranken. Auch andere berührungslos messende Sensoren sind zur Erfassung der Kante 12 des Gutes 1 geeignet. In Abhängigkeit vom Werkstoff des Gutes sind dies z. B. induktive und kapazitive Kantendetektoren oder Ultraschallsensoren.

Die Positionieraktoren 8 und ihre Achsen 9 mit den zugehörigen Wegmeßsytemen 16, sowie die in Kombination der daran befestigten Begrenzer 10 und der Kantendetektoren 11 bilden jeweils eine konstruktive Baueinheit. Durch das reversierende Ein- und Ausfahren der Achsen 9 der Positionieraktoren 8 werden die Begrenzer 10 geöffnet und geschlossen. Das Öffnen geschieht mindestens soweit, dass beim Absenken der Greifvorrichtung 3 an einer Abholposition die Begrenzer 10 das Gut 1 auch bei dem maximal vorkommenden Versatz 6 nicht berühren.

Nach dem Absenken der Greifvorrichtung 3 oder nach dem Ergreifen des Gutes werden die Begrenzer 10 an der Kante 12 des Gutes 1 positioniert. Dieses Begrenzen erfolgt unter Kontrolle des Steuerungssystems der Anlage. Die erfolgte Positionierung zeigt die **Figur 1** **b**. Die Kantendetektoren 11 neben den Begrenzern 10 lösen während des Schließens der Begrenzer beim individuellen Detektieren der Kante 12 über das Steuerungssystem oder direkt das Anhalten der Schließbewegungen der jeweiligen Positionieraktoren aus. Die Achsen 9 der Positionieraktoren 8 sind dann soweit eingefahren, dass die Kante 12 des Gutes 1 von den Begrenzern 10 gerade noch nicht berührt wird. Die Größe der dabei zu bildende Spalten 13 zwischen der Kante 12 und der dieser gegenüber stehenden Mantellinie des Begrenzers 10 richtet sich nach der erforderlichen Positioniergenauigkeit des Gutes auf der Zielposition. In der Praxis kann dieser Spalt z. B. 0,1 mm betragen, wodurch sich dadurch eine maximale Abweichung der Lage des Gutes in der Zielposition von ebenfalls 0,1 mm ergibt.

In der Praxis weisen die Abmessungen der Güter Toleranzen auf, die größer als der einstellbare minimale Spalt 13 ist. Hier erweist sich die Erfindung als besonders vorteilhaft, weil die Toleranzen der Abmessungen des Gutes 1 die Positioniergenauigkeit nicht beeinflussen. Die Begrenzer werden auch bei einem toleranzbehafteten Gut 1 stets so positioniert, dass die vorgesehene Größe des Spaltes 13 erreicht wird. Damit kann auch bei größeren Toleranzen der Abmessungen des Gutes 1 sichergestellt werden, dass die Gutmitte 5 in der Zielposition genau auf der Sollposition abgelegt wird.

Dies wäre mit einem Greifer nach dem Stand der Technik mit fest eingestellten seitlichen Begrenzern nicht möglich, denn diese müssen so weit eingestellt werden, dass beim Ergreifen das Gut mit der größten positiven Toleranz der Abmessungen und mit dem größten Versatz auf den Ablagen von den Begrenzern nicht getroffen, d. h. nicht beschädigt werden kann. Entsprechend sehr ungenau wird dann besonders das Gut mit den größten negativen Toleranzen der Abmessungen auf der Zielposition abgelegt.

Nach dem Begrenzen wird in den Figuren 1 das Gut 1 zunächst von einem Greifer 14 bevorzugt durch Ansaugen gegriffen. Geeignet sind z. B. Vakuumgreifer, Saugvorrichtungen und Bernoulli-Greifer oder magnetische Greifer. Diese Situation zeigt die **Figur 1** **c.** Die Begrenzer 10 befinden sich in der geschlossenen Position am Gut 1. Daher ist ein Wegschwimmen des Gutes beim und nach dem Ergreifen nicht möglich. Anschließend wird der Greifer 14 bzw. die Greifvorrichtung 3 mittels des Handhabungsgerätes oder Roboterarmes zusammen mit dem Gut 1 zur Zielposition transportiert. Erst nach dem Ablegen werden die Begrenzer 10 vom Gut 1 entfernt, d. h. geöffnet. Von daher kann das Gut 1 auch beim Transport und besonders beim Ablegen nicht wegschwimmen. Die Begrenzer halten dieses in der vor dem Aufnehmen von ihnen eingenommenen Lage. Die dabei individuell eingenommenen Stellungen der Begrenzer 10, d. h. der Achsen 9 der Positionieraktoren 8 sind in einer dem Steuerungssystem bekannten Lage. Erfindungsgemäß werden diese Stellungen der Begrenzer 10 sowie ihre von der Form des Gutes abhängige Anzahl derselben und ihre Ausrichtung auf der Greifvorrichtung 3 zur Berechnung des Versatzes 6 und dessen Richtung genutzt. Das Steuerungssystem berechnet aus den von den Wegmeßsystemen 16 ermittelten Wegdaten der für die Form des Gutes 1 ausreichend vielen Positionieraktoren 8 die tatsächliche Lage des Gutes 1 oder die Gutmitte 5 in Bezug zur Bezugslinie 4, d. h. den Versatz 6 und dessen Richtung. Das Steuerungssystem ist dann in der Lage, das Gut 1 unter Korrektur des Versatzes 6 exakt in die Zielposition zu steuern und es dort abzulegen. Die erforderliche Positioniergenauigkeit wird damit zuverlässig erreicht. Dies sowohl bei toleranzbehaftetem Gut als auch sehr vorteilhaft bei unterschiedlichen Gütern verschiedener Nennmaße innerhalb von bestimmten Grenzen, z. B. für Solarzellen mit den Abmessungen 125 mm² und 156 mm².

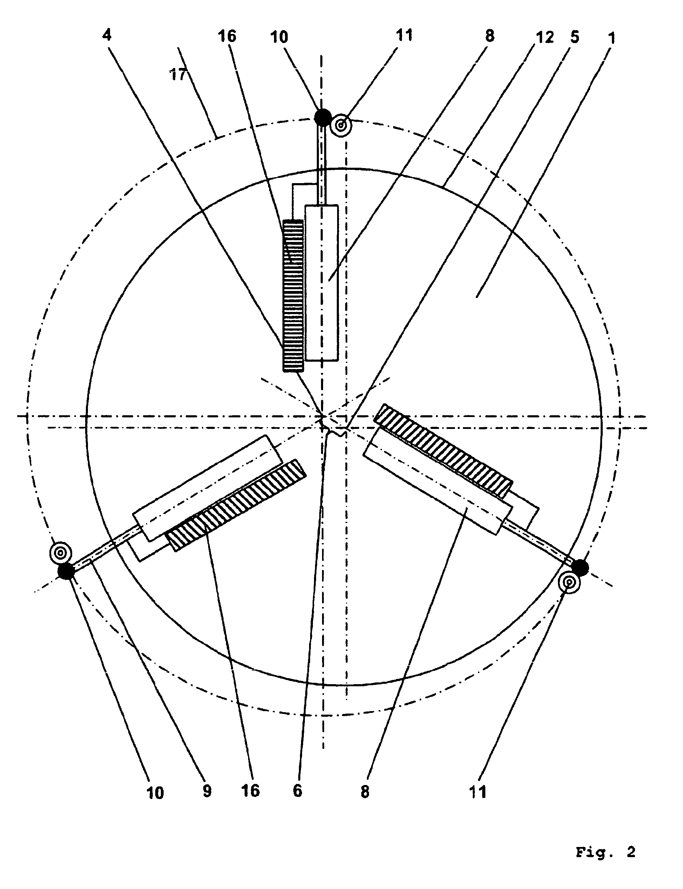

Die **Figur 2** zeigt in der Draufsicht ein rundes Gut 1, z. B. einen abgelegten Wafer, dessen Gutmitte 5 sich mit dem Bezugslinie 4 der Greifvorrichtung 3 nicht deckt. Diese Bezugslinie 4 ist vom Steuerungssystem exakt in die Sollposition der Abholposition gesteuert worden. Es besteht ein Versatz 6. Die Greifvorrichtung 3 ist mit drei maximal bis zum Teilkreis 17 geöffneten Begrenzern 10 und daran befestigten Kantendetektoren 11 über dem Gut 1 positioniert. Diese Endposition 17 der Begrenzer 10 ermöglicht das Absenken, ohne dabei das Gut 1 zu berühren.

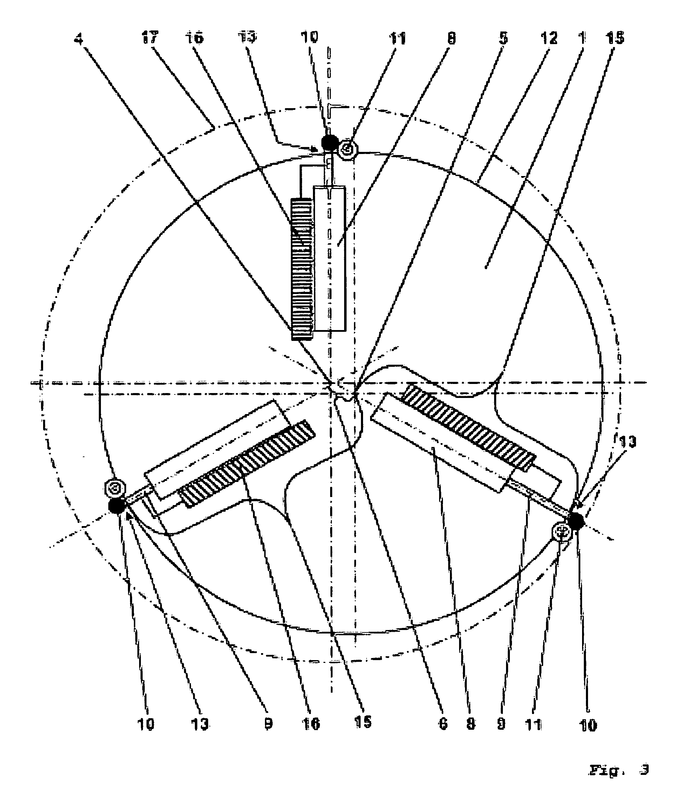

**Die** **Figur 3** zeigt die Situation mit an der Kante 12 des Gutes positionierten Begrenzern. Die Kante 12 wurde von den drei Kantendetektoren 11 individuell erfasst. Die Achsen 9 sind entsprechend der Lage des Gutes 1 bzw. des Versatzes 6 unterschiedlich weit in die Positionieraktoren 8 eingefahren. Hierüber hat das Steuerungssystem mittels der Wegmeßsysteme 16, die mit den Positionieraktoren 8 verbunden sind oder eine konstruktive Baueinheit bilden, Kenntnis. Mit der bekannten Zusatzinformation, dass es sich in diesem Beispiel um ein kreisrundes Gut handelt, kann die Gutmitte 5, d. h. der Mittelpunkt des Kreises vom Steuerungssystem berechnet werden. Dieser liegt dort, wo sich gemessen z. B. von den Mantellinien der Begrenzer 10 gleich lange Strecken 15 bzw. Radien in einem Punkte treffen. Damit und weil ein Wegschwimmen des Gutes durch die Begrenzer ausgeschlossen worden ist, kann das Gut vom Handhabungsgerät oder Roboterarm an der Zielposition exakt abgelegt werden. Bei einem Gut mit einer anderen Form, z. B. eine quadratische Solarzelle mit bekannten Abmessungen, sind entsprechend der geometrischen Erfordernisse mindestens vier Positionieraktoren 8 erforderlich, um bei einem unbestimmt liegenden Gut die Gutmitte 5 sowie die Richtung und den Betrag des Versatzes 6 zu berechnen.

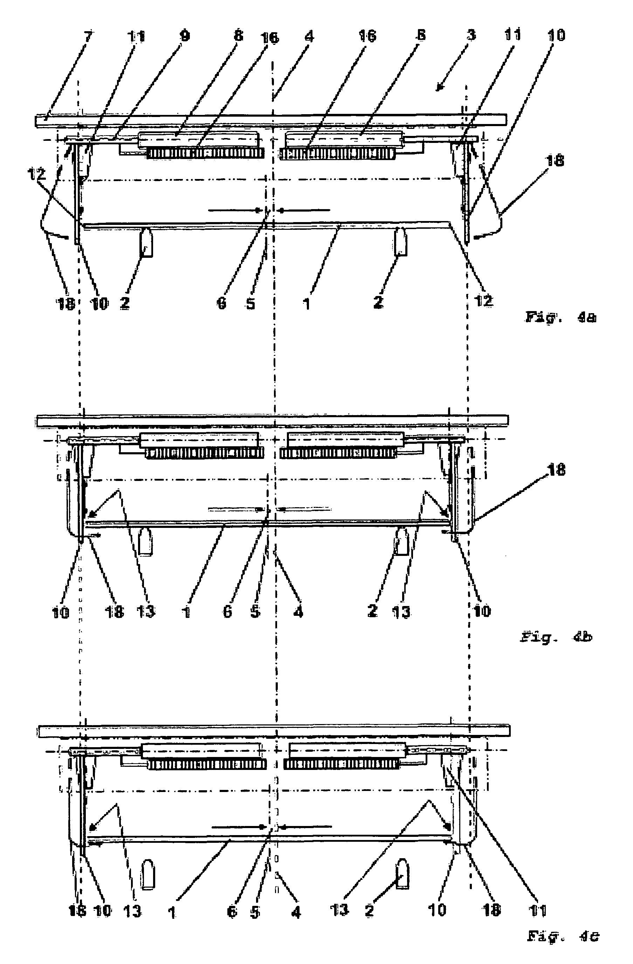

Die Figuren 4 zeigen eine Greifvorrichtung 3 mit mechanischen Trägern 18 zum Ergreifen und Transportieren des Gutes 1. In der **Figur 1a** ist die Greifvorrichtung 3 in der Abholposition mit geöffneten Positionieraktoren 8 und ausgeschwenkten Trägern 18 positioniert. Die mindestens zwei Träger 18 sind z. B. schwenkbar oder linear beweglich mittels mindestens eines nicht dargestellten Aktors an der Greifvorrichtung 3 angeordnet. Die Träger 18 sind in dem dargestellten Beispiel als Bügel mit punktförmiger oder großflächiger Auflage für das Gut gestaltet. Auch ein elastischer, das Gut sehr schonend tragender Werkstoff, kann an den Berührungsflächen von Gut 1 und Träger 18 verwendet werden. Die Form der Träger 18 sowie ihr Aktionsbereich sind so dimensioniert, dass Sie sowohl über dem größten zu tragenden Gut im geöffneten Zustand positioniert werden können, als auch das kleinste zu tragende Gut noch sicher erfassen und tragen können.

Die Figur 4b zeigt den Beginn des Ergreifens des Gutes bzw. des Tragens. Die Träger 18 sind eingeschwenkt. Sie haben das Gut unterfahren. Die Positionieraktoren 8 mit den Begrenzern 10 sind an den Kanten 12 des Gutes positioniert. Die Fortsetzung des Ergreifens und Transportierens zeigt die **Figur 4c**. Das Gut liegt auf den mechanischen Trägern 18. Es wird gegen ein Verschieben während des Transportes und beim Ablegen in der Zielposition durch die positionierten Begrenzer 10 gesichert.

### Bezugszeichenliste

- 1: Gut, Substrat, Wafer, Solarzelle
- 2: Ablage
- 3: Greifvorrichtung
- 4: Bezugslinie, Nullpunkt
- 5: Gutmitte
- 6: Versatz
- 7: Adapter
- 8: Positionieraktor
- 9: Achse
- 10: Begrenzer
- 11: Kantendetektor, Sensor
- 12: Kante des Gutes
- 13: Spalt
- 14: Greifer
- 15: Strecke, Radius
- 16: Wegmeßsystem
- 17: Teilkreis, Endposition
- 18: Träger

## Patentansprüche

1. Vorrichtung zum Transport in bevorzugt horizontaler oder geneigter Lage von Gut (1) wie bruchempfindlichen Substraten als Wafer oder Solarzellen in gesteuerten Produktionsanlagen von einer Ablagestelle eines Nass- oder Trockenprozesses zur nächsten mittels einer Greifvorrichtung (3), mit mindestens einem Greifer (14) oder Träger (18), der oder die sich an einem Handhabungsgerät oder an einem Roboterarm befinden, **gekennzeichnet** je Greifer (14) oder Träger (18) durch mindestens zwei Positionieraktoren (8) zur kontrollierten gemeinsamen Verlagerung je eines Kantendetektors (11), mit mindestens einem Begrenzer (10).

2. Vorrichtung nach Patentanspruch 1, **gekennzeichnet durch** ein Wegmeßsystem (16), das mit der Achse (9) des Positionieraktors (8) und damit auch mit dem Kantendetektor (11), und mindestens mit einem Begrenzer (10) zu deren kontrollierten gemeinsamen Verlagerung mechanisch verbunden ist.

3. Vorrichtung nach Patentanspruch 1 oder 2, **gekennzeichnet durch** ein Wegmeßsystem (16), als inkrementales Wegmeßsystem mit einem Referenzpunkt an einer Endposition (17) oder als absolutes Wegmeßsystem.

4. Vorrichtung nach einem der Patentansprüche 1 bis 3, **gekennzeichnet durch** einen Positionieraktor (8) als pneumatischen, elektrischen, hydraulischen oder magnetischen Linearantrieb oder Schwenkantrieb.

5. Vorrichtung nach einem der Patentansprüche 1 bis 4, **gekennzeichnet durch** Kantendetektoren (11) zur Erfassung der Kante (12) des Gutes als optische, magnetische, induktive, kapazitive Sensoren oder Ultraschallsensoren.

6. Vorrichtung nach einem der Patentansprüche 1 bis 5, **gekennzeichnet durch** eine Justierung der oder des Begrenzer(s) (10) und des Kantendetektors (11) auf der Achse (9) derart, dass nach dem Einfahren aller Begrenzer (10) das Gut (1) an dessen Kante (12) nicht geklemmt wird.

7. Vorrichtung nach einem der Patentansprüche 1 bis 6, **gekennzeichnet durch** mindestens zwei Träger (18) als punktförmig tragende Bügel oder großflächige Auflagen zum Ergreifen des Gutes **durch** Unterfahren und Ausheben desselben.

8. Vorrichtung nach einem der Patentansprüche 1 bis 7, **gekennzeichnet durch** eine Anordnung und Verteilung der Positionieraktoren (8) und ihre Ausrichtungen auf der Greifvorrichtung (3) derart, dass bei eingefahrenen Begrenzern (10) das begrenzte Gut nicht wegschwimmen oder verschoben werden kann.

9. Verfahren zum Transport in bevorzugt horizontaler oder geneigter Lage von Gut (1) wie bruchempfindlichen Substraten als Wafer oder Solarzellen in gesteuerten Produktionsanlagen von einer Ablagestelle eines Nass- oder Trockenprozesses zur nächsten mittels einer Greifvorrichtung (3), mit mindestens einem Greifer (14) oder Träger (18), der oder die sich an einem Handhabungsgerät oder an einem Roboterarm befinden, unter Verwendung der Vorrichtung nach Anspruch 1, **gekennzeichnet durch** die Verfahrensschritte:
a) Positionieren der Greifvorrichtung (3) mit ausgefahrenen Begrenzern (10) und Trägern (18) über dem aufzunehmenden Gut (1), das sich in einer toleranzbehafteten Lage in der Abholposition befindet; und
b) Ergreifen des Gutes (1) mittels des Greifers (14) oder der Träger (18); und
c) Transport des Gutes zur Zielposition; und
f) Absenken der Greifvorrichtung (3) und Ablegen des Gutes auf Ablagen (2) der Zielposition; und
g) Öffnen der Begrenzer (10) nach dem Ablegen; wobei
h) die Begrenzer (10) **durch** eine Schließbewegung mittels individueller Positionieraktoren (8) an der Kante (12) des in unbekannter Lage befindlichen Gutes positioniert werden, und dass dabei aus den mittels Wegmeßsystemen (16) individuell gemessenen Positionen der Begrenzer, die dem Steuerungssystem der Anlage mitgeteilt werden, der Versatz (6) und die Richtung des Versatzes berechnet wird, wobei dieses Positionieren der Begrenzer (10) zwischen den Verfahrensschritten a) und b) oder b) und c) oder während des Verfahrensschrittes c) eingefügt wird.

10. Verfahren nach Patentanspruch 9, **dadurch gekennzeichnet, dass** das Ergreifen des Gutes (1) saugend durch Unterdruck oder durch Unterfahren mittels mindestens zwei Träger (18) und Ausheben erfolgt.

11. Verfahren nach Patentanspruch 9 oder 10, **dadurch gekennzeichnet, dass** mittels des berechneten Versatzes (6) und dessen Richtung die Sollkoordinaten der Zielpositionen derart vom Steuerungssystem vorzeichengerecht korrigiert werden, dass das Gut an der Zielposition vom Handhabungsgerät oder Roboterarm korrekt abgelegt wird.

12. Verfahren nach einem der Patentansprüche 9 bis 11, **dadurch gekennzeichnet, dass** beim Schließen der Begrenzer (10) die mit ihnen verbundenen Kantendetektoren (11) bei Erreichen der Kante (12) des Gutes diese erkennen und die Schließbewegungen der Positionieraktoren (8) individuell mittels des Steuerungssystems oder direkt gesteuert so anhalten, dass einerseits das Gut nicht geklemmt wird und andererseits eine zulässige Breite des Spaltes (13) nicht überschritten wird.

13. Verfahren nach einem der Patentansprüche 9 bis 12, **dadurch gekennzeichnet, dass** mindestens beim Ablegen ein Wegschwimmen oder Verschieben des Gutes durch die positionierten Begrenzer (10) verhindert wird.

14. Verfahren nach einem der Patentansprüche 9 bis 13, **dadurch gekennzeichnet, dass** die Wegmeßsysteme (16) die gemessenen Wegdaten in Bezug zu jeweiligen Referenzpunkten oder Endpositionen als Messwerte dem Steuerungssystem zur Berechnung des Versatzes (6) und dessen Richtung mitteilt.

15. Verfahren nach einem der Patentansprüche 9 bis 14, **dadurch gekennzeichnet, dass** Gut mit unterschiedlichen Formen oder Vielecken durch eine dafür ausreichend große Anzahl von Begrenzern (10) begrenzt wird, die eine eindeutige Berechnung des Versatzes und dessen Richtung ermöglicht.

16. Verfahren nach einem der Patentansprüche 9 bis 15, **dadurch gekennzeichnet, dass** unterschiedlich große Nennmaße der Güter durch entsprechend weite lineare oder schwenkende Bewegungen der Achsen (9) und/oder der Träger (18) gehandhabt werden.

## Claims

1. Apparatus for the transport of good (1) such as fragile substrates as wafers or solar cells preferably in a horizontal or inclined orientation in controlled production plants from one deposition area of a wet or dry process to the next by means of a gripper device (3) with at least one gripper (14) or carrier (18) being arranged at a manipulation device or a robotic arm, each gripper (14) or carrier (18) being **characterized by** at least two positioning actuators (8) for the controlled combined displacement of one respective edge detector (11) with at least one delimiter (10).

2. Apparatus according to claim 1, **characterized by** a position sensor (16) which is mechanically connected with the axis (9) of the positioning actuator (8), and therefore, also with the edge detector (11), and with at least one delimiter (10), for their controlled combined displacement.

3. Apparatus according to claim 1 or 2, **characterized by** a position sensor (16) as an incremental position sensor with a reference point at an end position (17), or as an absolute position sensor.

4. Apparatus according to one of claims 1 to 3, **characterized by** a positioning actuator (8) as pneumatic, electric, hydraulic, or magnetic linear drive or swivel drive.

5. Apparatus according to one of claims 1 to 4, **characterized by** edge detectors (11) for the registration of the edge (12) of the good as optical, magnetic, inductive, capacitive sensors or ultrasound sensors.

6. Apparatus according to one of claims 1 to 5, **characterized by** an adjustment of the delimiter(s) (10) and of the edge detector (11) onto the axis (9) in such a manner that the good (1) is not clamped at its edge (12) after the retraction of all delimiters (10).

7. Apparatus according to one of claims 1 to 6, **characterized by** at least two carriers (18) as punctiformly carrying bows or large-area supports for gripping the good by underriding and lifting the same.

8. Apparatus according to one of claims 1 to 7, **characterized by** an arrangement and distribution of the positioning actuators (8) and their orientations on the gripper device (3) in such a manner that the delimited good cannot swim or be pushed away upon retracted delimiters (10).

9. Method for the transport of good (1) such as fragile substrates as wafers or solar cells preferably in a horizontal or inclined orientation in controlled production plants from one deposition area of a wet or dry process to the next by means of a gripper device (3) with at least one gripper (14) or carrier (18) arranged at a manipulation device or a robotic arm, by using an apparatus as defined in claim 1, **characterized by** the process steps:
a) positioning of the gripper device (3) with extended delimiters (10) and carriers (18) above the good (1) to be picked up which is present in the pick-up position in a position having tolerances; and
b) gripping the good (1) by means of the gripper (14) or the carriers (18); and
c) transport of the good to the target position; and
d) lowering the gripper device (3) and depositing the good on supports (2) of the target position; and
e) opening the delimiters (10) after depositing; wherein
f) the delimiters (10) are positioned as a result of a closing motion by means of individual positioning actuators (8) at the edge (12) of the good which is present in an unknown position, and that, by means of the positions of the delimiters which are individually determined by means of position sensors (16) and which are fed to the control system of the plant, the offset (6) and the direction of the offset is calculated, wherein this positioning of the delimiters (10) is inserted between the process steps a) and b), or b) and c), or during the process step c).

10. Method according to claim 9, **characterized in that** the gripping of the good (1) takes places by sucking by means of vacuum, or by underriding by means of at least two carriers (18) and lifting.

11. Method according to claim 9 or 10, **characterized in that** the desired coordinates of the target positions are corrected with proper algebraic sign by the control system by means of the calculated offset (6) and its direction in such a manner that the good is correctly disposed at the target position by the manipulation device or the robotic arm.

12. Method according to one of claims 9 to 11, **characterized in that** during closing of the delimiters (10), the edge detectors (11) which are connected with them detect the edge (12) of the good when reaching the same, and stop the closing motions of the positioning actuators (8) individually by means of the control system or directly controlled in such a manner that on one hand, the good is not clamped, and on the other hand, an allowable width of the gap (13) is not exceeded.

13. Method according to one of claims 9 to 12, **characterized in that** at least during depositing, a swimming away or displacement of the good is prevented by the positioned delimiters (10).

14. Method according to one of claims 9 to 13, **characterized in that** the position sensors (16) feed the determined route data with reference to respective reference points or end positions as measured values to the control system for calculation of the offset (6) and its direction.

15. Method according to one of claims 9 to 14, **characterized in that** good with different shapes or polygons is delimited by a therefore sufficient number of delimiters (10) which allows for a distinct calculation of the offset and its direction.

16. Method according to one of claims 9 to 15, **characterized in that** nominal dimensions of different values of the goods are handled by accordingly wide linear or swiveling motions of the axes (9) and/or of the carriers (18).

## Revendications

1. Dispositif pour le transport de biens (1) tels que des substrats fragiles comme des plaquettes de silicium (wafer) ou des cellules photovoltaïques, de préférence en position horizontale ou en position inclinée dans des installations industrielles contrôlées à partir d'une aire de dépôt d'un procédé sec ou humide jusqu'à la suivante en utilisant un dispositif préhenseur (3) avec au moins un préhenseur (14) ou un porteur (18) qui se trouvent dans un équipement manipulateur ou un bras robotique, **caractérisé** au niveau de chaque préhenseur (14) ou chaque porteur (18) par au moins deux positionneurs (8) qui contrôlent ensemble le placement d'un détecteur d'arête (11), avec au moins un limiteur (10).

2. Dispositif selon la revendication 1, **caractérisé par** un système de mesure de distance (16) qui est relié mécaniquement avec l'axe (9) des positionneurs (8) et ainsi aussi avec le détecteur d'arête (11), et au moins un limiteur (10) pour le placement contrôlé coordonné.

3. Dispositif selon les revendications 1 ou 2, **caractérisé par** un système de mesure de distance (16) tel qu'un système de mesure de distance incrémentiel avec un point de référence à une position terminale (17) ou tel qu'un système de mesure de distance absolu.

4. Dispositif selon une des revendications 1 à 3, **caractérisé par** un positionneur (8) tel qu'une commande linéaire ou une commande rotative, pneumatique, électrique, hydraulique ou magnétique.

5. Dispositif selon une des revendications 1 à 4, **caractérisé par** des détecteurs d'arête (11) pour capter le bord (12) du bien tels que des senseurs optiques, magnétiques, à induction, à capacité ou des senseurs à ultrasons.

6. Dispositif selon une des revendications 1 à 5, **caractérisé par** un ajustement du ou des limiteurs (10) et du détecteur d'arête (11) sur l'axe (9) de telle manière qu'après la descente de tous les limiteurs (10), le bien (1) ne sera pas coincé par ses bords (12).

7. Dispositif selon une des revendications 1 à 6, **caractérisé par** au moins deux porteurs (18) tels que des étriers porteurs sur un point ou des supports de grande surface pour saisir le bien par-dessous et en le soulevant.

8. Dispositif selon une des revendications 1 à 7, **caractérisé par** une disposition et répartition des positionneurs (8) et leur orientation sur le dispositif préhenseur (3) de telle manière que lorsque les limiteurs (10) sont en place, le bien retenu ne peut pas s'éloigner en flottant ou être déporté.

9. Procédé pour le transport de biens (1) tels que des substrats fragiles comme des plaquettes de silicium (wafer) ou des cellules photovoltaïques, de préférence en position horizontale ou en position inclinée dans des installations industrielles contrôlées à partir d'une aire de dépôt d'un procédé sec ou humide jusqu'à la suivante en utilisant un dispositif préhenseur (3) avec au moins un préhenseur (14) ou un porteur (18) qui se trouvent dans un équipement manipulateur ou un bras robotique, en utilisant un dispositif selon la revendication 1, **caractérisé par** les étapes de procédé :
a) Positionner le dispositif préhenseur (3) avec limiteurs (10) et porteurs (18) en place au dessus du bien (1) à prendre qui se trouve avec une certaine tolérance en position de départ; et
b) Préhension du bien (1) au moyen du préhenseur (14) ou du porteur (18) ; et
c) Transport du bien jusqu'à la position cible ; et
d) Descente du dispositif préhenseur (3) et dépôt du bien sur le reposoir (2) de la position cible ; et
e) Ouverture du limiteur (10) après le dépôt; à l'occasion de quoi
f) Les limiteurs (10) par un mouvement de fermeture par l'intermédiaire des positionneurs individuels (8) sont positionnés aux bords (12) du bien qui se trouve dans un position indéfinie, et en même temps, les positions des limiteurs sont mesurées individuellement au moyen du système de mesure de distance (16) et sont communiquées au système de commande de l'installation, le décalage (6) et la direction du décalage sont calculés, le mouvement des limiteurs (10) étant appliqué entre les étapes a) et b) ou b) et c) ou bien pendant l'étape c).

10. Procédé selon la revendication 9, **caractérisés en ce que** la préhension du bien (1) se produit par une aspiration par sous-pression ou par le positionnement d'au moins deux porteurs (18) sous le bien et le relèvement de ceux-ci.

11. Procédé selon la revendication 9 ou 10, **caractérisé en ce que** par l'intermédiaire du décalage (6) calculé et sa direction, les coordonnées enregistrées de la position cible sont corrigées de telle manière par le système de commande que le bien est déposé correctement à la position cible par l'équipement manipulateur ou le bras robotique.

12. Procédé selon une des revendications 9 à 11, **caractérisé en ce que** lors de la fermeture des limiteurs (10), les détecteurs d'arête (11) qui leur sont liés reconnaissent le bord (12) du bien en l'atteignant et le mouvement de fermeture des positionneurs (8), contrôlé individuellement directement ou par l'intermédiaire du système de commande, est arrêté de telle manière que d'un coté le bien n'est pas coincé et de l'autre coté une largeur admissible de la fente (13) n'est pas dépassée.

13. Procédé selon une des revendications 9 à 12, **caractérisé en ce que** au moins au moment du dépôt, un éloignement par flottaison ou un décalage du bien sont empêchés par le positionnement des limiteurs (10).

14. Procédé selon une des revendications 9 à 13, **caractérisé en ce que** le système de mesure de distance (16) communique les données de distance mesurées par rapport à un point de référence ou à la position finale comme données au système de commande pour le calcul du décalage (6) et sa direction.

15. Procédé selon une des revendications 9 à 14, **caractérisé en ce que**, des biens de formes différentes ou polygonaux sont retenus par un nombre suffisamment grand de limiteurs qui permet un calcul univoque du décalage et de sa direction.

16. Procédé selon une des revendications 9 à 15, **caractérisé en ce que** des biens de côtes nominales de différentes grandeurs sont manipulés par des mouvements linéaires ou rotatifs des axes (9) et/ou des porteurs (18) d'ampleur correspondante.
